# EUROPEAN PATENT APPLICATION

(11) **EP 4 776 058 A1**
(43) Date of publication of application: **15.07.2026**
(21) Application number: 25168961.8
(22) Date of filing: 07.04.2025
(51) Int. Cl.: G02F 1/1333, H05K 7/20, G06F 1/16, G06F 1/20

(54) **DISPLAY DEVICE**

(30) Priority: 14.01.2025 KR 20250005514
(71) Applicant: LG Electronics Inc., Yeongdeungpo-gu Seoul 07336 (KR)
(72) Inventor: KIM, Dongyun, Seoul 07796 (KR)
(74) Representative: Vossius & Partner Patentanwälte Rechtsanwälte mbB

(57) **Abstract**

Provided is a display device including a display panel, a cabinet covering a periphery of the display panel, a front glass fastened to the cabinet, positioned in front of the display panel, and defining a front space with the display panel therebetween, a cover bottom covering a rear surface of the display panel, a back cover coupled to a rear surface of the cover bottom and defining a rear space with the cover bottom therebetween, connecting flow channels connecting the front space with the rear space between the cover bottom and the cabinet at both ends in a first direction, respectively, an outer air inlet defined in the back cover and constructed to allow outer air to be introduced thereinto, a radiator that is connected to the outer air inlet and absorbs heat of inner air in the rear space, a cover flow channel formed in the back cover, wherein outer air that has passed through the radiator passes through the cover flow channel, and an outer air outlet constructed to discharge outer air that has passed through the cover flow channel.

## Description

### TECHNICAL FIELD

The present disclosure relates to a display device having a heat dissipation structure that is easy to maintain.

### BACKGROUND

A display device includes a display that outputs an image, and various types of display devices are being released based on a size of the display. In particular, recently, more various types of display devices have emerged by reducing a thickness of the display and using various materials.

There are various types, such as a portable display device, a display device used indoors, and a display device used for outdoor advertisements. In case of the portable display, a size is small and a high-resolution thin and light display is used to output various images on a small screen.

A display device that provides various contents and messages via the display device rather than a hardware medium, such as a signboard or a poster for outdoor advertisements, is being used. Recently, with a rapid development of intelligent digital imaging devices based on an LED and an OLED, there is a need for a large display device.

The outdoor display device should be able to operate normally even with a temperature change equal to or greater than 60° by being exposed to an outdoor temperature difference. In particular, when the display device is operated, heat is generated in a display panel and a printed circuit board, and it is very important to lower a temperature of components in the display device in a high temperature environment.

### DISCLOSURE

### TECHNICAL PROBLEM

The present disclosure is to provide a display device having a heat dissipation structure with increased heat dissipation efficiency to solve the above-described problem.

### TECHNICAL SOLUTION

Provided is a display device including a display panel, a cabinet covering a periphery of the display panel, a front glass fastened to the cabinet, positioned in front of the display panel, and defining a front space with the display panel therebetween, a cover bottom covering a rear surface of the display panel, a back cover coupled to a rear surface of the cover bottom and defining a rear space with the cover bottom therebetween, connecting flow channels connecting the front space with the rear space between the cover bottom and the cabinet at both ends in a first direction, respectively, an outer air inlet defined in the back cover and constructed to allow outer air to be introduced thereinto, a radiator that is connected to the outer air inlet and absorbs heat of inner air in the rear space, a cover flow channel formed in the back cover, wherein outer air that has passed through the radiator passes through the cover flow channel, and an outer air outlet constructed to discharge outer air that has passed through the cover flow channel.

The display device may further include a closed loop fan module that is positioned on the cover bottom and circulates air in the rear space in the first direction.

The radiator may extend in a second direction perpendicular to the first direction, and the outer air inlet may be located at an end in the second direction.

The display device may further include an open loop fan module that introduces air into the outer air inlet.

The radiator may include a pair of radiators arranged symmetrically in a longitudinal direction, and respective ends of the pair of radiators may be connected to the single cover flow channel.

The cover flow channel may include an inclined portion having a thickness decreasing as the outer air outlet becomes closer.

The first direction may be a horizontal direction.

The display device may have a rectangular shape having a long side in the first direction, and the radiator may include a plurality of radiators spaced apart from each other in the first direction.

The display device may have a rectangular shape having a short side in the first direction, and the radiator may extend in a second direction perpendicular to the first direction and include a plurality of radiators arranged side by side in the second direction.

The radiator may include a plurality of heat exchange flow channels allowing air in the rear space to pass therethrough.

The radiator may include a heat dissipation fin having one side positioned inside the radiator and protruding into the rear space.

The display device may further include a printed circuit board mounted on the rear surface of the cover bottom.

### ADVANTAGEOUS EFFECTS

The display device of the present disclosure may implement the long open loop to more effectively absorb and discharge the heat of air in the closed loop.

An additional range of applicability of the present disclosure will become apparent from the following detailed description. However, because various changes and modifications within the spirit and scope of the present disclosure may be clearly understood by those skilled in the art, it should be understood that the detailed description and the specific embodiment such as the preferred embodiment of the present disclosure are given only by way of example.

### BRIEF DESCRIPTION OF THE DRAWINGS

FIG. 1 is a front perspective view illustrating a display device according to an embodiment of the present disclosure.
FIG. 2 is a rear perspective view illustrating a display device according to an embodiment of the present disclosure.
FIG. 3 is a perspective view illustrating a state in which a back cover of a display device according to an embodiment of the present disclosure is removed.
FIG. 4 is a cross-sectional view taken along a line A-A in FIG. 3.
FIG. 5 is a view of a portion B in FIG. 3 viewed in a first direction.
FIG. 6 is a rear perspective view illustrating a flow channel of a back cover of a display device of the present disclosure.
FIG. 7 is a conceptual diagram illustrating a heat dissipation structure of an existing display device and a heat dissipation structure of a display device of the present disclosure.
FIGS. 8 and 9 are exploded perspective views illustrating display devices according to other embodiments of the present disclosure.

### DETAILED DESCRIPTION

Description will now be given in detail according to exemplary embodiments disclosed herein, with reference to the accompanying drawings. For the sake of brief description with reference to the drawings, the same or equivalent components may be provided with the same reference numbers, and description thereof will not be repeated. In general, a suffix such as "module" and "unit" may be used to refer to elements or components. Use of such a suffix herein is merely intended to facilitate description of the specification, and the suffix itself is not intended to give any special meaning or function. In the present disclosure, that which is well-known to one of ordinary skill in the relevant art has generally been omitted for the sake of brevity. The accompanying drawings are used to help easily understand various technical features and it should be understood that the embodiments presented herein are not limited by the accompanying drawings. As such, the present disclosure should be construed to extend to any alterations, equivalents and substitutes in addition to those which are particularly set out in the accompanying drawings.

It will be understood that although the terms first, second, etc. may be used herein to describe various elements, these elements should not be limited by these terms. These terms are generally only used to distinguish one element from another.

It will be understood that when an element is referred to as being "connected with" another element, the element can be directly connected with the other element or intervening elements may also be present. In contrast, when an element is referred to as being "directly connected with" another element, there are no intervening elements present.

A singular representation may include a plural representation unless it represents a definitely different meaning from the context.

Terms such as "include" or "has" are used herein and should be understood that they are intended to indicate an existence of several components, functions or steps, disclosed in the specification, and it is also understood that greater or fewer components, functions, or steps may likewise be utilized.

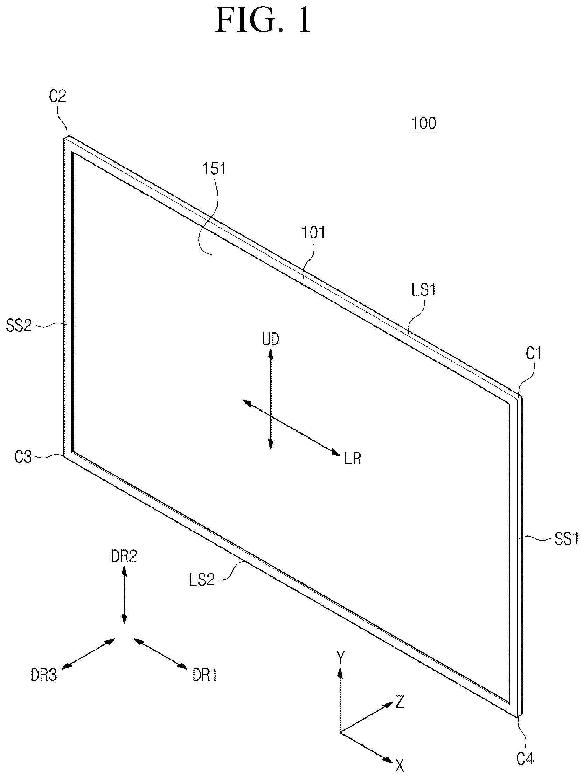

FIG. 1 is a perspective view illustrating a display device 100 according to an embodiment of the present disclosure. Referring to FIG. 1, the display device 100 may have a rectangular body including a pair of long sides LS1 and LS2 and a pair of short sides SS1 and SS2. The long sides and the short sides may be referred to as edges of the display device 100.

Points at which the long sides and the short sides meet each other may be referred to as corners C1, C2, C3, and C4.

The long side extending in a horizontal direction and the short side extending in a vertical direction are illustrated in the drawings, but the long side and the short side may have the same length, and the long side may be disposed in the vertical direction.

A first direction DR1 is a horizontal direction LR of the display device 100, and is the same as a direction parallel to the long sides LS1 and LS2 in the present embodiment.

A second direction DR2 is a vertical direction UD of the display device 100, and may be a direction parallel to the short sides SS1 and SS2 in the present embodiment. A third direction DR3 may be a direction perpendicular to the first direction DR1 and/or the second direction DR2.

The display device illustrated in FIG. 1 may be disposed such that a longitudinal direction thereof is vertical in addition to being disposed such that the long side direction is horizontal.

A side where the display device 100 displays an image may be referred to as a front side or a front surface. A side where the image is not able to be observed when the display device 100 displays the image may be referred to as a rear side or a rear surface.

The display device of the present disclosure may include a display panel 150 positioned on the front surface and a cabinet 101 covering a periphery of the display panel 150. The display panel 150 may include a display panel including a plurality of pixels, and each of the plurality of pixels in the display panel 150 may include RGB subpixels. Alternatively, each of the plurality of pixels in the display panel may include RGBW subpixels. The display module 151 may convert an image signal, a data signal, an OSD signal, and a control signal processed by the controller 180 to generate a driving signal for the plurality of pixels.

The display panel 150 may include a liquid crystal display (LCD), a light emitting diode (LED), an organic light emitting diode (OLED), and the like.

The LCD may control a color of each pixel using a liquid crystal, and may receive light via a backlight unit because it is difficult to emit light by itself. The backlight unit is a device that uniformly supplies light supplied from a light source to the liquid crystals positioned on the front surface. As the backlight unit becomes thinner, a thin LCD may be implemented.

The LED or the OLED may be implemented so as to be curved, since an element constituting each pixel is self-emissive, and therefore no backlight unit is used. In addition, since each element is self-emissive, the brightness of the element is not affected even though the positional relationship between adjacent elements is changed, and therefore it is possible to implement a curved display module 150 using the LED or the OLED.

A light-emitting diode (LED) panel is based on technology of using one LED element as one pixel. Since it is possible to reduce the size of the LED element, compared to a conventional device, it is possible to increase a resolution, and implement a curved display module 150. The LED has a high luminance and thus is clearly visible even outdoors under strong sunlight, so that the LED is used as an an outdoor billboard. It consumes less power than other display technologies and has a longer lifespan, so that a maintenance cost is low. Using an RGB LED, a screen that has an excellent color expression and is more lively may be provided.

An organic light-emitting diode (OLED) panel appeared in earnest in mid 2010 and has rapidly replaced the LCD in the small- or medium-sized display market. The OLED is a display manufactured using a self-emissive phenomenon of an organic compound in which the organic compound emits light when current flows in the organic compound. The response time of the OLED is shorter than the response time of the LCD, and therefore afterimages hardly appear when video is implemented.

The OLED is an emissive display product that uses three fluorescent organic compounds having a self-emissive function, such as red, green, and blue fluorescent organic compounds and that uses a phenomenon in which electrons injected at a negative electrode and a positive electrode and particles having positive charges are combined in the organic compounds to emit light, and therefore a backlight unit, which deteriorates color, is not needed.

The cabinet 101 may have a frame shape and may cover a front surface and a side periphery of the display panel 150. A front glass 105 may be positioned on a front surface of the cabinet 101 to cover the front surface of the display panel 150. The front glass 105 may be disposed to be spaced apart from the display panel 150 by a predetermined distance, and may include a front space between the display panel 150 and the front glass 105.

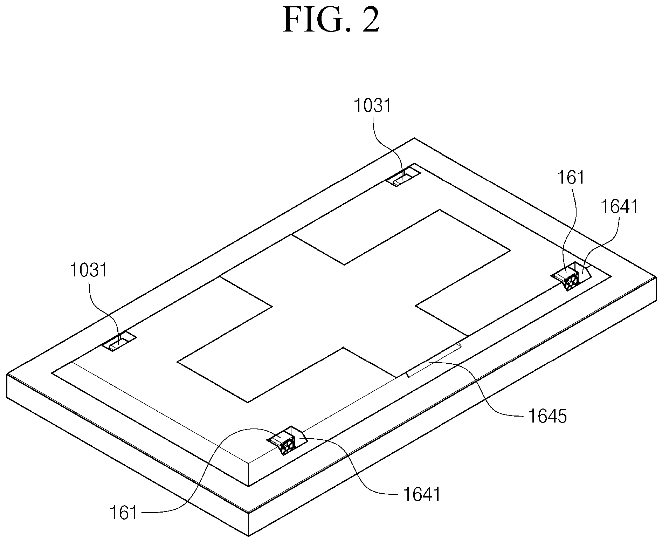

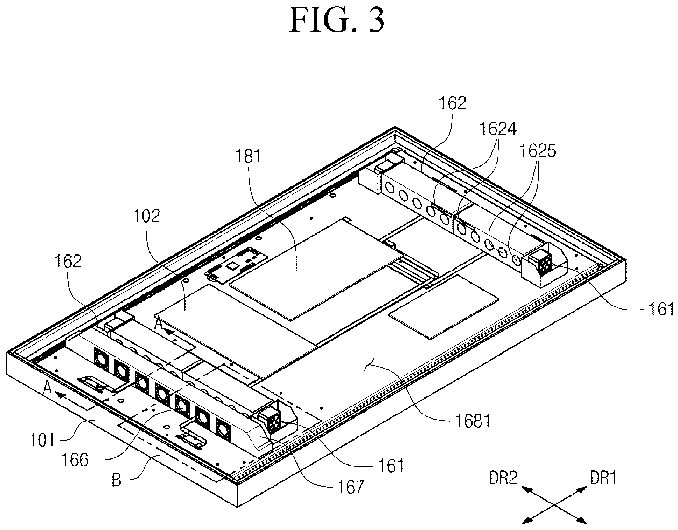

FIG. 2 is a rear perspective view illustrating the display device 100 according to an embodiment of the present disclosure, and FIG. 3 is a perspective view illustrating a state in which a back cover 103 of the display device 100 according to an embodiment of the present disclosure is removed.

When outer air is introduced into the display device 100, dust or foreign substances contained in the outer air may be introduced, causing a failure of the display device 100. In particular, the display device 100 installed outdoors may limit the inflow of outer air into the display device 100 because of a high degree of outer air pollution.

However, in this case, a temperature of the display device 100 may increase by heat generated from the display panel 150, a printed circuit board 181 controlling the display panel 150, and the like, thereby affecting a performance.

Accordingly, the display device 100 of the present disclosure may prevent outer air from flowing into the display device 100 via a heat dissipation structure composed of an open loop 164 and a closed loop 168. The open loop 164 refers to a circulation structure into which outer air is introduced and through which outer air passes, and the closed loop 168 is a circulation structure of air inside the display device 100 and is not mixed with outer air.

As illustrated in FIG. 3, the display device 100 may include a cover bottom 102 covering a rear surface of the display panel 150 and an electronic component such as the printed circuit board 181 mounted on a rear surface of the cover bottom 102, and may include a back cover 103 covering the rear surface of the cover bottom 102.

The closed loop 168 may include a front space 1683 between the display panel 150 and the front glass 105, a rear space 1681 between the cover bottom 102 and the back cover 103, and a connecting flow channel 1682 connecting the front space 1683 with the rear space, and may include a closed loop fan module 166 that induces a flow of air to circulate through the rear space, the connecting flow channel 1682, and the front space 1683.

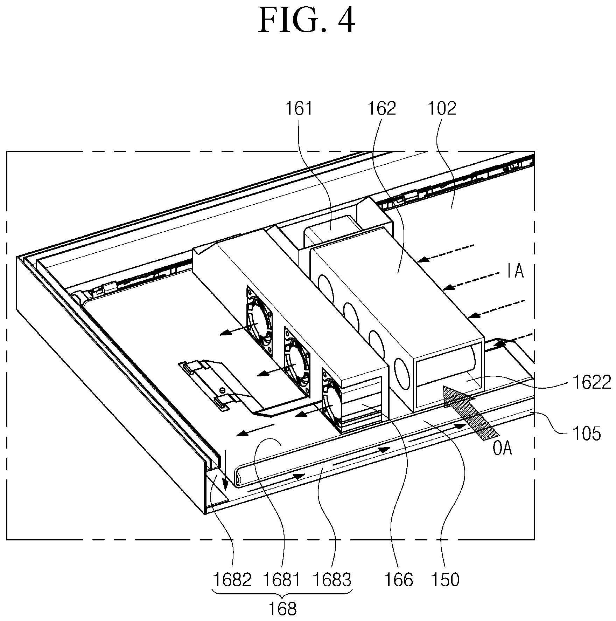

FIG. 4 is a cross-sectional view taken along a line A-A in FIG. 3. The closed loop fan module 166 may be designed such that air circulates in the first direction DR1, and a plurality of closed loop fan modules 166 may be arranged side by side in the second direction in a fan bracket 167. When the first direction in which inner air (IA) circulates along the closed loop 168 is the horizontal direction, air in the closed loop 168 may evenly circulate without being accumulated in a lower portion.

The connecting flow channels 1682 may be located on both sides in the first direction DR1, and to implement the connecting flow channels 1682, at least portions of the cover bottom 102 may be spaced apart from the cabinet 101 on both sides in the first direction DR1.

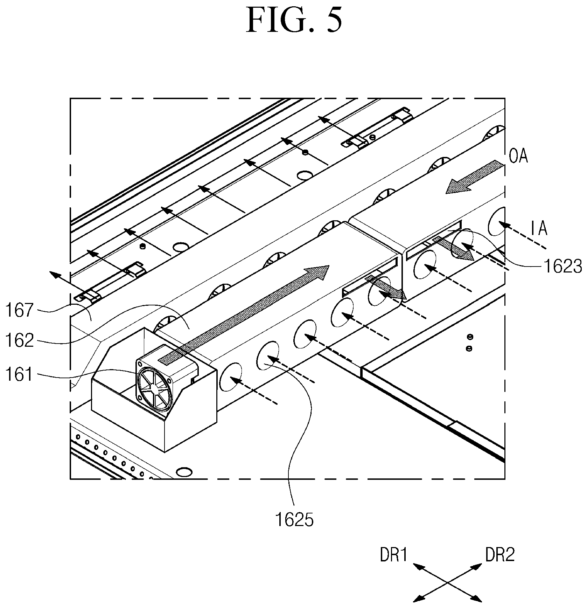

FIG. 5 is a view of a portion B in FIG. 3 viewed in the first direction DR1. A radiator 162 may be disposed adjacent to the closed loop fan module 166, and the radiator 162 may include an open flow channel 1622 through which outer air OA passes.

The radiator 162 may be connected to an outer air inlet 1641 defined in the back cover 103. To urge the inflow of outer air OA into the radiator 162, the display device 100 may include an open loop fan module 161 located inside the outer air inlet 1641.

Outer air OA introduced from the outer air inlet 1641 of the back cover 103 is introduced into the radiator 162 and exchanges heat with inner air IA circulating through the closed loop 168 in the radiator 162.

The radiator 162 may include a plurality of heat exchange flow channels 1625 extending in the first direction DR.1 to facilitate the heat exchange with inner air IA. The heat exchange flow channel 1625 may increase a surface area of the radiator 162 to achieve the heat exchange between low-temperature outer air OA positioned inside the radiator 162 and high-temperature inner air AI positioned outside the radiator 162.

The radiator 162 may extend in the second direction DR2 perpendicular to the first direction DR1, which is the circulation direction of the closed loop 168, such that the heat exchange between inner air IA and outer air OA is performed efficiently. For efficiency, a pair of radiators 162 may be arranged side by side in the second direction DR2, and the outer air inlets 1641 may be located at both ends in the second direction DR2, so that the pair of radiators 162 may be arranged symmetrically in the second direction DR2.

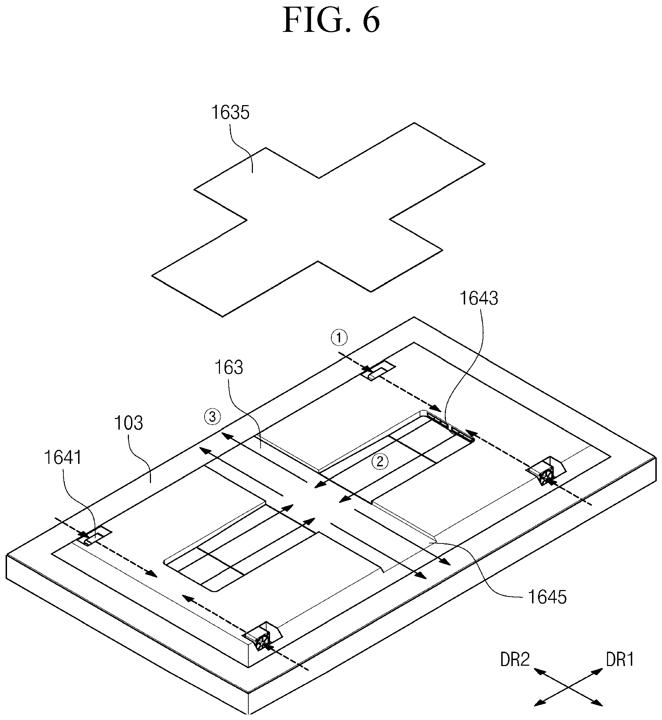

FIG. 6 is a rear perspective view illustrating a cover flow channel 163 of the back cover 103 of the display device 100 of the present disclosure. An arrow in FIG. 6 indicates a flow of outer air OA.

The open loop 164 of the present disclosure further includes the cover flow channel 163 connected from the radiator 162. The cover flow channel 163 formed in the back cover 103 may include a connection portion 1643 connected to an outlet 1623 of the radiator 162, and the outlets 1623 of the two radiators 162 may be connected to the one cover flow channel 163.

Outer air ① that has passed through the radiator 162 may not be immediately discharged to an outer air outlet 1645, but may pass through the cover flow channel 163 ② and may additionally exchange heat with inner air located on a front surface of the back cover 103. A shape of the cover flow channel 163 may not be limited and may be designed such that air passes through a great area on the back cover 103.

An end of the cover flow channel 163 may be connected to the outer air outlet 1645, so that outer air that has passed through the cover flow channel 163 may be discharged ③ to the outer air outlet 1645. The cover flow channel 163 may include an inclined portion designed to become thinner as it is closer to the outer air outlet 1645, so that a decrease in a speed of air in the cover flow channel 163 may be minimized.

The cover flow channel 163 has a flow channel having a great width and a small thickness to minimize an increase in the thickness of the display device 100 and obtain heat exchange efficiency in a wide area. Because of characteristics of the shape of the cover flow channel 163, it is not easy to implement the cover flow channel 163 when the back cover 103 is constructed as one piece.

It is necessary to prevent outer air passing through the cover flow channel 163 from flowing into an inner space of the display device 100, but because the back cover 103 and a rear surface 1635 of the cover flow channel 163 are not sealed, even when outer air leaks, a performance is not significantly affected.

Therefore, for convenience of manufacturing, as illustrated in FIG. 6, a front surface and side surfaces of the cover flow channel 163 may be implemented in the back cover 103, and the rear surface 1635 of the cover flow channel 163 may be constructed as a separate piece.

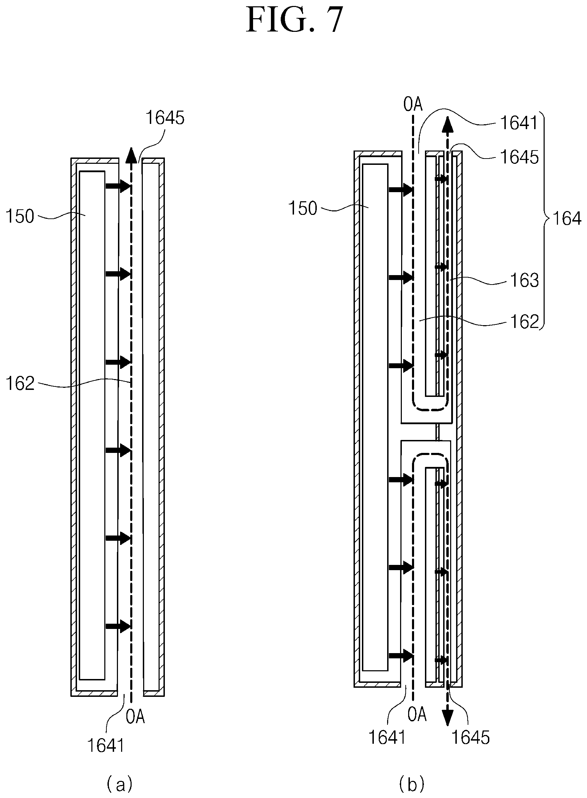

FIG. 7 is a conceptual diagram illustrating a heat dissipation structure of the existing display device 100 and a heat dissipation structure of the display device 100 of the present disclosure. (a) is a view showing the open loop 164 of the existing display device 100, and outer air introduced from the outer air inlet 1641 is able to perform the heat exchange only in the radiator 162.

However, as shown in (b) in FIG. 7 showing the heat dissipation structure of the display device 100 of the present disclosure, the open loop 164 may be extended via the cover flow channel 163, thereby further increasing the heat exchange efficiency.

When the radiator 162 is enlarged, there is a problem in that an area occupied in the rear space is widened and a mounting space of other electronic components becomes insufficient. However, the display device 100 of the present disclosure may improve heat dissipation efficiency while minimizing an increase in cost via the cover flow channel 163.

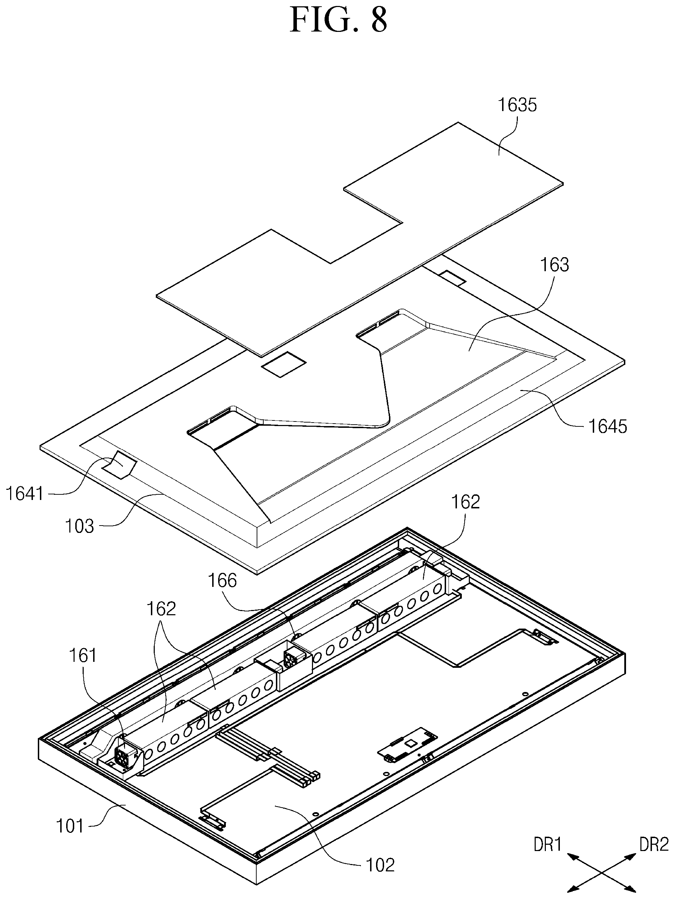

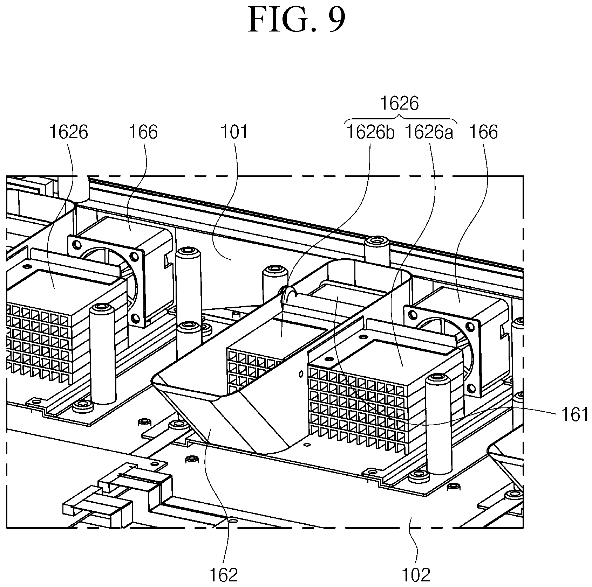

FIGS. 8 and 9 are exploded perspective views illustrating display devices 100 according to other embodiments of the present disclosure.

According to an embodiment in FIG. 8, the radiator 162 is disposed in the long side direction, and air in the closed loop 168 circulates in the short side direction. That is, the display device 100 may be installed such that the first direction DR1 becomes the short side direction, the second direction DR2 becomes the long side direction, and the short side is horizontal.

Unlike the embodiment in FIG. 3 in which the radiators 162 are arranged to be spaced apart from each other in the first direction DR1, in the embodiment in FIG. 8, because a length in the first direction DR1 is small, a plurality of radiators 162 may be arranged side by side in the second direction DR2.

The embodiment in FIG. 9 may have a shape in which the radiator 162 extends in the first direction DR1, which is the circulation direction of inner air. Because the closed loop 168 and the open loop 164 are not orthogonal to each other, it is difficult to implement a flow channel extending through the radiator 162, so that a heat dissipation fin 1626 having high thermal conductivity may be used.

Included is the heat dissipation fin 1626 in which one side 1626a of the heat dissipation fin 1626 is located outside the radiator 162 to come into contact with inner air passing through the closed loop 168, and the other side 1626b is located inside the radiator 162 to come into contact with outer air passing through the open loop 164.

The heat dissipation fin 1626 may transfer heat absorbed at one side 1626a of the heat dissipation fin 1626 to outer air at the other side 1626b using a material having high thermal conductivity to discharge heat to the outside.

The heat dissipation fin 1626 may include a thin plate-shaped member to increase a contact area, and as shown in FIG. 9, may be formed in a shape including a plurality of flow channels extending in the first direction DR1, which is the air flow direction.

As described above, the display device 100 of the present disclosure may implement the long open loop 164 to more effectively absorb and discharge the heat of air in the closed loop 168.

It will be apparent to those skilled in the art that the present disclosure may be embodied in other specific forms without departing from the spirit and essential features of the present disclosure.

The above detailed description should not be construed as being limitative in all terms, but should be considered as being illustrative. The scope of the present invention should be determined by reasonable analysis of the accompanying claims, and all changes in the equivalent range of the present invention are included in the scope of the present invention.

## Claims

1. A display device (100) comprising:
a display panel (150);
a cabinet (101) covering a periphery of the display panel (150);
a front glass (105) fastened to the cabinet (101), positioned in front of the display panel (150), and defining a front space (1683) with the display panel (150) therebetween;
a cover bottom (102) covering a rear surface of the display panel (150);
a back cover (103) coupled to a rear surface of the cover bottom (102) and defining a rear space (1681) with the cover bottom (102) therebetween;
connecting flow channels (1682) connecting the front space (1683) with the rear space (1681) between the cover bottom (102) and the cabinet (101) at both ends in a first direction, respectively;
an outer air inlet (1641) defined in the back cover (103) and constructed to allow outer air to be introduced thereinto;
a radiator (162) connected to the outer air inlet (1641) and configured to absorb heat of inner air in the rear space (1681);
a cover flow channel (163) formed in the back cover (103), wherein outer air that has passed through the radiator (162) passes through the cover flow channel (163); and
an outer air outlet (1645) constructed to discharge outer air that has passed through the cover flow channel (163).

2. The display device (100) of claim 1, further comprising a closed loop fan module (166) positioned on the cover bottom (102) and configured to circulate air in the rear space (1681) in the first direction.

3. The display device (100) of claim 1 or claim 2, wherein the radiator (162) extends in a second direction perpendicular to the first direction, and the outer air inlet (1641) is located at an end in the second direction.

4. The display device (100) of one of claims 1 to 3, further comprising an open loop fan module (161) configured to introduce air into the outer air inlet (1641).

5. The display device (100) of claims 1 to 4, wherein the radiator (162) includes a pair of radiators (162) arranged symmetrically in a longitudinal direction,
wherein respective ends of the pair of radiators (162) are connected to the single cover flow channel (163).

6. The display device (100) of one of claims 1 to 5, wherein the cover flow channel (163) includes an inclined portion having a thickness decreasing as the outer air outlet (1645) becomes closer.

7. The display device (100) of one of claims 1 to 6, wherein the first direction is a horizontal direction.

8. The display device (100) of one of claims 1 to 7, wherein the display device (100) has a rectangular shape having a long side in the first direction,
wherein the radiator (162) includes a plurality of radiators (162) spaced apart from each other in the first direction.

9. The display device (100) of one of claims 1 to 8, wherein the display device (100) has a rectangular shape having a short side in the first direction,
wherein the radiator (162) extends in a second direction perpendicular to the first direction and includes a plurality of radiators (162) arranged side by side in the second direction.

10. The display device (100) of one of claims 1 to 9, wherein the radiator (162) includes a plurality of heat exchange flow channels (1652) allowing air in the rear space to pass therethrough.

11. The display device (100) of one of claims 1 to 10, wherein the radiator (162) includes a heat dissipation fin (1626) having one side positioned inside the radiator (162) and protruding into the rear space.

12. The display device (100) of one of claims 1 to 11, further comprising a printed circuit board (181) mounted on the rear surface of the cover bottom (102).

## Amended claims

### Amended claims in accordance with Rule 137(2) EPC.

1. A display device (100) comprising:
a display panel (150);
a cabinet (101) covering a periphery of the display panel (150);
a front glass (105) fastened to the cabinet (101), positioned in front of the display panel (150), and defining a front space (1683) with the display panel (150) therebetween;
a cover bottom (102) covering a rear surface of the display panel (150);
a back cover (103) coupled to a rear surface of the cover bottom (102) and defining a rear space (1681) with the cover bottom (102) therebetween;
connecting flow channels (1682) connecting the front space (1683) with the rear space (1681) between the cover bottom (102) and the cabinet (101) at both ends in a first direction, respectively;
an outer air inlet (1641) defined in the back cover (103) and constructed to allow outer air to be introduced thereinto;
a radiator (162) connected to the outer air inlet (1641) and configured to absorb heat of inner air in the rear space (1681);
a cover flow channel (163) formed in the back cover (103), wherein outer air that has passed through the radiator (162) passes through the cover flow channel (163);
an outer air outlet (1645) constructed to discharge outer air that has passed through the cover flow channel (163);
a closed loop fan module (166) positioned on the cover bottom (102) and configured to circulate air in the rear space (1681) in the first direction; and
an open loop fan module (161) configured to introduce air into the outer air inlet (1641).

2. The display device (100) of claim 1, wherein the radiator (162) extends in a second direction perpendicular to the first direction, and the outer air inlet (1641) is located at an end in the second direction.

3. The display device (100) of claims 1 to 3, wherein the radiator (162) includes a pair of radiators (162) arranged symmetrically in a longitudinal direction,
wherein respective ends of the pair of radiators (162) are connected to the single cover flow channel (163).

4. The display device (100) of one of claims 1 to 3, wherein the cover flow channel (163) includes an inclined portion having a thickness decreasing as the outer air outlet (1645) becomes closer.

5. The display device (100) of one of claims 1 to 4, wherein the first direction is a horizontal direction.

6. The display device (100) of one of claims 1 to 5, wherein the display device (100) has a rectangular shape having a long side in the first direction,
wherein the radiator (162) includes a plurality of radiators (162) spaced apart from each other in the first direction.

7. The display device (100) of one of claims 1 to 6, wherein the display device (100) has a rectangular shape having a short side in the first direction,
wherein the radiator (162) extends in a second direction perpendicular to the first direction and includes a plurality of radiators (162) arranged side by side in the second direction.

8. The display device (100) of one of claims 1 to 7, wherein the radiator (162) includes a plurality of heat exchange flow channels (1652) allowing air in the rear space to pass therethrough.

9. The display device (100) of one of claims 1 to 8, wherein the radiator (162) includes a heat dissipation fin (1626) having one side positioned inside the radiator (162) and protruding into the rear space.

10. The display device (100) of one of claims 1 to 9, further comprising a printed circuit board (181) mounted on the rear surface of the cover bottom (102).
